# EUROPÄISCHE PATENTANMELDUNG

(11) **EP 2 925 105 A2**
(43) Veröffentlichungstag der Anmeldung: **30.09.2015**
(21) Anmeldenummer: 15157278.1
(22) Anmeldetag: 03.03.2015
(51) Int. Cl.: H05K 7/14

(54) **ELEKTRONIKMODUL FÜR EIN HAUSHALTSGERÄT SOWIE VERFAHREN ZUR MONTAGE EINES ELEKTRONIKMODULS**

(30) Priorität: 18.03.2014 DE 102014204954
(71) Anmelder: BSH Hausgeräte GmbH, 81739 München (DE)
(72) Erfinder: Adam, Paul, 93161 Sinzing / Viehhausen (DE)

(57) **Zusammenfassung**

Die Erfindung betrifft ein Elektronikmodul (1) für ein Haushaltsgerät, mit einer ersten Leiterplatte (2) und einer separaten zweiten Leiterplatte (3), die beabstandet zueinander angeordnet sind und mit einem Leiterplatte-zu-Leiterplatte-Steckverbinder (4) elektrisch verbunden sind, wobei die beiden Leiterplatten (2, 3) Aufnahmen (2h, 2i, 3a, 3b) für Montage-Justageelemente (8, 9) aufweisen, welche zur Justage der Leiterplatten (2, 3) zueinander bei der Montage in die Aufnahmen (2h, 2i, 3a, 3b) einführbar sind. Die Erfindung betrifft auch ein Verfahren zum Montieren eines Elektronikmoduls (1).

## Beschreibung

Die Erfindung betrifft ein Elektronikmodul für ein Haushaltsgerät mit einer ersten Leiterplatte und einer dazu separaten zweiten Leiterplatte, die beabstandet zueinander angeordnet sind und mit einem Leiterplatte-zu-Leiterplatte-Steckverbinder (board to board connector) elektrisch verbunden sind. Des Weiteren betrifft die Erfindung ein Verfahren zur Montage eines derartigen Elektronikmoduls.

In Haushaltsgeräten zur Pflege von Wäschestücken oder zum Zubereiten von Lebensmitteln oder zum Reinigen von Geschirr oder zum Lagern und Konservieren von Lebensmitteln, wie beispielsweise einem Wäschetrockner, einer Waschmaschine, einem Backofen, einem Kochfeld, einem Geschirrspüler, einem Kühlgerät, einem Gefriergerät, einem Kühl-Gefrier-Kombigerät, sind Elektronikmodule verbaut. Diese Elektronikmodule umfassen Anzeigeeinheiten und/oder eine Bedienvorrichtung mit Bedienelementen. Dadurch können die Geräte in ihren Betriebsbedingungen eingestellt werden und Informationen an der Anzeigeeinheit elektronisch angezeigt werden. Darüber hinaus sind auch Ausgestaltungen bekannt, bei denen derartige Elektronikmodule multimediafähig und interaktionsfähig sind. Dies bedeutet, dass optische und akustische Informationen wiedergegeben und/oder empfangen werden können und darüber hinaus zusätzlich oder anstatt dazu auch Interaktionen mit einem Nutzer erfolgen können. Dies kann beispielsweise durch Gestenerkennung oder Spracherkennung sowie auch durch entsprechende Touchberührungen eines berührsensitiven Bedienfelds zu Interaktionen zwischen dem Gerät und dem Nutzer führen.

Derartige Elektronikmodule weisen üblicherweise zumindest zwei separate Schaltungsträger beziehungsweise Platinen beziehungsweise Leiterplatten auf, die in dem Elektronikmodul angeordnet sind und die beabstandet zueinander angeordnet sind. Sie sind üblicherweise mit einem sogenannten Leiterplatte-zu-Leiterplatte-Steckverbinder elektrisch verbunden. Dabei ist ein derartiger Steckverbinder üblicherweise als in sich formstabile und steife Leiste ausgebildet, die als Träger für daran angeordnete elektrische Kontakte gestaltet ist. Dieser Steckverbinder ist dann auch in mechanischem Kontakt mit diesen beiden Leiterplatten.

Elektronikmodule, wie sie auch bekannt sind, weisen in dem Zusammenhang eine Leiterplatte, die als Multimedia-Leiterplatte (multimedia board) und eine weitere Leiterplatte als Interaktions-Leiterplatte (interaction board) auf. Diese beiden verschiedenen Leiterplatten sind somit insbesondere funktionell zur elektronischen Steuerung und Signalübertragung für unterschiedliche Zwecke ausgebildet, tauschen in dem Zusammenhang jedoch dann auch entsprechende Informationen über Signale aus.

Die Positionierung dieser Leiterplatten relativ zueinander ist relativ schwierig und führt bei herkömmlichen Ausgestaltungen bei der Montage dazu, dass aufgrund von unerwünschten Lagetoleranzen der Steckverbinder nicht genau positioniert werden kann und sich daher elektrische Kontaktverbindungen nur unzureichend ausbilden. Darüber hinaus kann es bei der Montage aufgrund dieser Lagetoleranzen zu Beschädigungen der elektrischen Kontakte kommen, die beispielsweise verbogen oder abgebrochen werden können.

Die Befestigung wird darüber hinaus aufgrund dieser Unwägbarkeiten bei herkömmlichen Montageszenarien so durchgeführt, dass die Anbringung des Steckverbinders quasi von Hand erfolgt und zusätzlich eine Befestigung mittels Schrauben durchgeführt wird. Dies ist sehr aufwändig und für die Großserienfertigung nachteilig.

Es ist Aufgabe der vorliegenden Erfindung, ein Elektronikmodul für ein Haushaltsgerät sowie ein Verfahren zur Montage eines derartigen Elektronikmoduls zu schaffen, bei welchem beziehungsweise mit welchem die lagegenaue Anordnung der Leiterplatten zueinander insbesondere auch schon während der Montage und dem Verbinden mit dem Steckverbinder erreicht ist.

Diese Aufgabe wird durch ein Elektronikmodul und einem Verfahren gemäß den unabhängigen Ansprüchen gelöst.

Ein erfindungsgemäßes Elektronikmodul für ein Haushaltsgerät umfasst eine erste Leiterplatte und eine dazu separate zweite Leiterplatte. Die beiden Leiterplatten sind beabstandet zueinander im Elektronikmodul angeordnet. Sie sind mit einem zu den Leiterplatten separaten Leiterplatte-zu-Leiterplatte-Steckverbinder elektrisch verbunden. Dieser Leiterplatte-zu-Leiterplatte-Steckverbinder ist insbesondere leistenartig ausgebildet und in sich formstabil beziehungsweise starr. Er weist vorzugsweise einen Träger aus Kunststoff auf, an dem elektrische Kontakte angeordnet sind. Diese sind zum elektrischen Kontaktieren mit elektrischen Kontakten auf der ersten Leiterplatte und mit elektrischen Kontakten auf der zweiten Leiterplatte ausgebildet. Ein wesentlicher Gedanke der Erfindung ist darin zu sehen, dass die beiden Leiterplatten jeweils Aufnahmen für Montage-Justageelemente aufweisen. Die Justageelemente sind zur Justage der Leiterplatten zueinander bei der Montage des Elektronikmoduls ausgebildet und in die Aufnahme einführbar. Es wird also ein Elektronikmodul geschaffen, welches bei Komponenten, die auch im vollständig montierten Endzustand des Elektronikmoduls verbaut sind, nämlich die beiden Leiterplatten, eine dauerhaft beständige Merkmalsausgestaltung aufweist, nämlich die Aufnahmen, bei denen es dann definiert und gezielt bei der Montage vorgesehen ist, Justagelemente einzuführen und dadurch die beiden Leiterplatten auch schon bei der Montage des Elektronikmoduls definiert und aktiv lagegenau zueinander auszurichten. Durch diese Ausgestaltung wird ein Elektronikmodul geschaffen, welches im fertigen Endzustand eine lagegenaue Anordnung der Leiterplatten zueinander und auch eine zuverlässig umfängliche elektrische Kontaktierung des Steckverbinders mit den Leiterplatten ergibt.

Vorzugsweise ist vorgesehen, dass jede Leiterplatte zumindest zwei separate Aufnahmen aufweist. Durch diese Ausgestaltung kann eine Mehrzahl von separaten Justageelementen gleichzeitig bei der Montage mit den Aufnahmen der Leiterplatten gekoppelt beziehungsweise hindurchgeführt werden und somit die lagegenaue Anordnung der Leiterplatten nochmals verbessert werden.

Vorzugsweise ist vorgesehen, dass die Aufnahmen durchgängige Löcher sind. Dadurch können Justageelemente hindurchgeführt werden, so dass auch beim weiteren Montageszenario ein Herausrutschen oder Verschieben der Justageelemente verhindert ist und somit auch bei der Montage dauerhaft und sicher diese lagegenaue Anordnung der Leiterplatten zueinander geschaffen ist. Auch die mechanische Kopplung zwischen den Justageelementen und den Leiterplatten ist durch diese spezifische Ausgestaltung der Aufnahmen in Form als durchgängige Löcher verbessert.

Vorzugsweise ist vorgesehen, dass zumindest ein Loch, insbesondere alle Löcher, eckenfrei in ihrer Umrandung beziehungsweise in ihrer Kontur ausgebildet sind. Gerade dann, wenn ein Justageelement als zylinderförmiger Stift ausgebildet ist, kann somit auch eine passgenaue und schnelle Einbringung erfolgen.

Es kann vorgesehen sein, dass zumindest ein Loch in seiner begrenzten Kontur kreisrund oder als Langloch ausgebildet ist. Durch eine Ausgestaltung in kreisrunder Form wird die bereits oben genannte passgenaue und schnelle Einbringung eines Justageelements begünstigt. Bei einer Ausgestaltung als Langloch kann im eingeführten Zustand eines Justageelements auch noch eine gewisse Nachjustage der Positionslagen der Leiterplatten zueinander erfolgen, was gegebenenfalls vorteilhaft sein kann.

Vorzugsweise ist vorgesehen, dass die zweite Leiterplatte flächenmäßig kleiner als die erste Leiterplatte ausgebildet ist.

Vorzugsweise ist vorgesehen, dass eine flächenmäßig kleinere Leiterplatte der beiden Leiterplatten funktionell als Multimedia-Leiterplatte ausgebildet ist. Insbesondere ist eine flächenmäßig im Vergleich der beiden Leiterplatten größere Leiterplatte, insbesondere die erste Leiterplatte funktionell als Interaktions-Leiterplatte ausgebildet.

Vorteilhaft ist es, dass eine Leiterplatte in einem Haltemodul angeordnet ist. Insbesondere ist die Anbringung einer flächenmäßig kleineren Leiterplatte, insbesondere der zweiten Leiterplatte, vorzugsweise einer Multimedia-Leiterplatte, in dem Haltemodul vorgesehen. Durch eine derartige Aufnahme ist es nicht mehr erforderlich, diese spezifische Leiterplatte mit zusätzlichen Befestigungselementen, wie beispielsweise Schrauben oder dergleichen zu befestigen.

Als besonders vorteilhaft ist eine derartige Anordnung einer Leiterplatte in einem Haltemodul vorgesehen und diese Leiterplatte ist in dem Haltemodul schwimmend gelagert. Dadurch können gerade bei einer Ausgestaltung einer derartigen Leiterplatte als Multimedia-Leiterplatte Stoßeinwirkungen und somit kurzseitige Kraftspitzen gedämpft werden beziehungsweise durch eine entsprechende schwimmende Lagerung eine gewisse Relativbewegung dieser Leiterplatte zum Haltemodul ermöglicht werden. Beschädigungen oder Funktionsbeeinträchtigungen zumindest dieser spezifischen Leiterplatte sind dann zumindest deutlich reduziert.

Vorzugsweise ist vorgesehen, dass das Haltemodul ein Halterahmenoberteil und ein Halterahmenunterteil aufweist und die Leiterplatte zwischen dem Halterahmenoberteil und dem Halterahmenunterteil angeordnet ist. Durch diese Ausgestaltung ist eine umlaufend und somit rahmenartig geschlossene Aufnahme der Leiterplatte ermöglicht, andererseits eine Zugänglichkeit von oben und von unten an die Leiterplatte gegeben, so dass hier auch mit den Leiterplatten zu verbindende Komponenten und insbesondere zusätzliche elektronische Bauteile, wie Display und dergleichen, einfach angeschlossen werden können und diesbezüglich kurze Signalwege bestehen. Darüber hinaus ist durch eine derartige Spezifikation des Haltemoduls eine besonders begünstige Trägerfunktionalität für diese Leiterplatte erreicht.

Vorzugsweise sind das Halterahmenoberteil und das Halterahmenunterteil separate Teile, die zerstörungsfrei lösbar verbindbar sind. Vorzugsweise sind hier Rastverbindungen oder Steckverbindungen oder eine Kombination von beiden vorgesehen. Es kann jedoch auch vorgesehen sein, dass das Halterahmenoberteil und das Halterahmenunterteil einstückig miteinander ausgebildet sind und beispielsweise mittels eines Filmscharniers verbunden sind und relativ zueinander bewegbar sind.

Vorteilhafterweise ist das Haltemodul zerstörungsfrei lösbar an der anderen Leiterplatte, die von dem Haltemodul nicht ausgenommen und insbesondere schwimmend gelagert gehalten ist, befestigt. Dadurch wird auch hier eine mechanisch stabile Anbringung erreicht und eine kompakte Anordnung geschaffen. Durch die zerstörungsfrei lösbare Anbringung des Haltemoduls kann dieses auch jederzeit reversibel entnommen und wieder angebracht werden und beispielsweise ein Austausch des Haltemoduls erfolgen.

Darüber hinaus ist durch ein Lösen dieses Haltemoduls auch die Zugänglichkeit zu Bereichen der beiden Leiterplatten ermöglicht, die im miteinander verbauten Endzustand nicht oder nur sehr schwer zugänglich sind. Es muss daher durch diese zerstörungsfrei lösbare Verbindung des Haltemoduls an der anderen Leiterplatte für Wartungs- oder Montagezwecke oder dergleichen nur das Haltemodul abgenommen werden und kann dann nach diesen Arbeiten wieder aufgesetzt werden und das Elektronikmodul weiter verwendet werden.

Vorzugsweise ist hier vorgesehen, dass das Haltemodul mit Rastelementen und/oder Steckelementen an der anderen Leiterplatte befestigt ist, wobei hier beispielsweise Schnapphaken, die federnd ausgebildet sind, vorgesehen sein können. Darüber hinaus können an diesem Haltemodul zusätzlich auch stiftartige Elemente angeordnet sein, die Steckverbindungen mit bezüglich weiterer Aufnahmen, insbesondere Löchern in der anderen Leiterplatte, eine mechanische Verbindung ermöglichen.

Vorzugsweise ist vorgesehen, dass der Leiterplatte-zu-Leiterplatte-Steckverbinder mit Rastelementen und/oder Steckelementen, insbesondere nur mit derartigen Rastelementen und/oder Steckelementen, mit den Leiterplatten verbunden ist. Zusätzliche Befestigungselemente, wie Schrauben oder dergleichen sind dann nicht mehr erforderlich, wodurch die Montage vereinfacht ist und dennoch die mechanisch stabile Halterung zumindest gleichwertig ermöglicht ist. Die bei Schraubverbindungen auftretenden Probleme mit Bruch des Steckverbinders und/oder der Leiterplatte können dadurch vermieden werden.

Bei einem erfindungsgemäßen Verfahren zur Montage eines Elektronikmoduls für ein Haushaltsgerät wird eine erste Leiterplatte beabstandet zu einer zweiten Leiterplatte in dem Elektronikmodul angeordnet und die beiden Leiterplatten werden mit einem Leiterplatte-zu-Leiterplatte-Steckverbinder elektrisch verbunden. Ein wesentlicher Gedanke der Erfindung ist darin zu sehen, dass die beiden Leiterplatten mit Aufnahmen ausgebildet werden, in welche bei der Montage des Elektronikmoduls Justageelemente zur Ausrichtung der Leiterplatten zueinander eingeführt werden. Dadurch kann bei der Fertigung des Elektronikmoduls eine lagegenaue Anordnung der beiden Leiterplatten zueinander erreicht werden und zwar bevor dann der Steckverbinder mit beiden Leiterplatten in Kontakt tritt und somit auch elektrische Kontakte miteinander in Verbindung kommen. Durch diese vorhergehende lagegenaue Ausrichtung der Leiterplatten zueinander wird dann verhindert, dass beim Anbringen des Steckverbinders die beiden Leiterplatten beziehungsweise beim Verbinden des an bereits eine Leiterplatte angebrachten Steckverbinders und der anderen Leiterplatte eine Beschädigung des Steckverbinders und/oder einer Leiterplatte auftritt, beispielsweise elektrische Kontakte verbogen oder abgebrochen werden.

Vorzugsweise werden die Justageelemente als vorauseilend angeordnet und somit vor dem mechanischen Kontaktieren des Leiterplatte-zu-Leiterplatte-Steckverbinders mit beiden Leiterplatten in die Aufnahmen in beide Leiterplatten sich erstreckend eingeführt. Eine derartige vorauseilende Anbringung der Ausgestaltung in die Justageelemente bedeutet somit, dass das Hindurcherstrecken der Justageelemente durch die Aufnahmen in beiden Leiterplatten bereits dann erfolgt ist, bevor der Steckverbinder mit beiden Leitenplatten in Kontakt tritt. In besonders vorteilhafter Weise ist somit dann die lagegenaue und gewünschte Ausrichtung der Leiterplatten zueinander bereits vor dem finalen Kontaktieren des Steckverbinders mit dann beiden Leiterplatten erreicht. Die lagegenaue Verbindung des Steckverbinders mit der dann verbleibenden zumindest einen Leiterplatte ist dann beim weiteren Annähern und Verbinden der Leiterplatten miteinander erreicht.

Vorzugsweise sind die Justageelemente als Justagestifte ausgebildet und die Justageelemente werden als separate Komponenten zu den anderen Bauteilen, insbesondere den Leiterplatten und des Steckverbinders bereitgestellt. Diese Justageelemente werden dann nach dem mechanischen Verbinden beider Leiterplatten mit dem Steckverbinder von dem diesbezüglich gefertigten Zwischenmodul mit den Leiterplatten und dem Steckverbinder wieder entfernt. Diese Justageelemente sind somit dann im endgültigen gefertigten Endzustand des Elektronikmoduls nicht mehr vorhanden, so dass sie lediglich bei der Montage als Ausrichtungshilfselemente dienen und dann nicht mehr benötigt werden. Durch eine derartige Ausgestaltung wird dann auch die Bauteilzahl des Elektronikmoduls reduziert und gerade dann, wenn, wie es vorteilhaft vorgesehen ist, relativ lange stabförmige Justageelemente verwendet werden, die dann in besonderem Maße als vorauseilende Justageelemente dienen, können durch dieses dann wiederum Entfernen der Justageelemente auch sehr flach bauende und kompakte Elektronikmodule geschaffen werden.

Durch eine derartige Ausgestaltung bei der Montage mit separaten und nachträglich wieder entnommenen Justageelementen kann auch eine kraftfreie Verbindung bei der Montage zwischen den Leiterplatten und dem Steckverbinder ermöglicht werden, wodurch die oben genannten Vorteile im Hinblick auf eine lagegenaue Verbindung und eine beschädigungsfreie Kontaktierung begünstigt wird.

Durch die Erfindung wird auch eine Konstruktion geschaffen, die eine kraftfreie Lagerung insbesondere der zweiten Leiterplatte, die vorzugsweise eine Multimedia-Leiterplatte ist, ermöglicht.

Bei der Erfindung kann in vorteilhafter Weise auch eine Vorfertigung einer Teileinheit beziehungsweise eines Zwischenmoduls geschaffen werden, welches dann nur mit dem Steckverbinder mit der weiteren Leiterplatte, insbesondere der ersten Leiterplatte, verbunden wird. Eine derartige vormontierte Einheit beziehungsweise ein Zwischenmodul umfasst vorzugsweise das Haltemodul und die zweite Leiterplatte. In dem Zusammenhang kann das Haltemodul einen Halterahmen für einen Bildschirm beziehungsweise eine Anzeigeeinheit, insbesondere ein TFT-Display, aufweisen, wobei dies vorzugsweise durch das Halterahmenoberteil gebildet ist. In dem Zusammenhang kann anstelle des Halterahmenoberteils zusätzlich oder anstatt dazu auch ein Deckel zum Abdecken dieser durch das Haltemodul gehaltenen Leiterplatte vorgesehen sein. Insbesondere durch das Halterahmenunterteil des Haltemoduls wird dann diese in dem Haltemodul gelagerte Leiterplatte aufgenommen beziehungsweise gehalten. Diese genannten Komponenten zählen in den erläuterten alternativen Ausführungen zu dem Zwischenmodul.

Wie bereits angesprochen, werden Kräfte, wie beispielsweise Vibrationskräfte oder die Einleitung von Schockkräften, die während der Lebensdauer beziehungsweise Nutzungsdauer auf das Elektronikmodul einwirken oder während der Umgebungssituation bestanden werden müssen, aufgrund dieser insbesondere schwimmenden Lagerung nicht in den Steckverbinder eingeleitet. Indem auch keine Schraubverbindungen zum Verbinden der Komponenten verwendet werden, können auch Drehmomente in Form von Quer- und Längskräften, die bei einem Schrauben auftreten, vermieden werden. Besonders vorteilhaft wird durch die Erfindung auch eine Großserienfertigung eines entsprechenden Elektronikmoduls ermöglicht, ohne, dass eine unerwünscht hohe Ausschussrate aufgrund von Beschädigungen des Steckverbinders und/oder der Leiterplatten auftreten würde. Dies kann darüber hinaus durch eine Reduktion der Montagezeit erreicht werden.

Weitere Merkmale der Erfindung ergeben sich aus den Ansprüchen, den Figuren und der Figurenbeschreibung. Die vorstehend in der Beschreibung genannten Merkmale und Merkmalskombinationen, sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind.

Ausführungsbeispiele der Erfindung werden nachfolgend anhand schematischer Zeichnungen näher erläutert. Es zeigen:
- Fig. 1: eine Explosionsdarstellung eines ersten Ausführungsbeispiels eines erfindungsgemäßen Elektronikmoduls;
- Fig. 2: eine Draufsicht auf die endmontierten Komponenten des Elektronikmoduls gemäß Fig. 1;
- Fig. 3: eine Schnittdarstellung durch die Ausgestaltung in Fig. 2;
- Fig. 4: eine vergrößerte Darstellung eines Teilausschnitts der Ansicht in Fig. 3;
- Fig. 5: eine perspektivische Darstellung eines spezifischen Montagezustands von Komponenten des Elektronikmoduls gemäß Fig. 1 bis Fig. 4;
- Fig. 6: eine Darstellung eines weiteren Ausführungsbeispiels von Komponenten eines Elektronikmoduls im montierten Zustand von unten; und
- Fig. 7: eine Explosionsdarstellung des Ausführungsbeispiels gemäß Fig. 5.

In den Figuren werden gleiche oder funktionsgleiche Elemente mit den gleichen Bezugszeichen versehen.

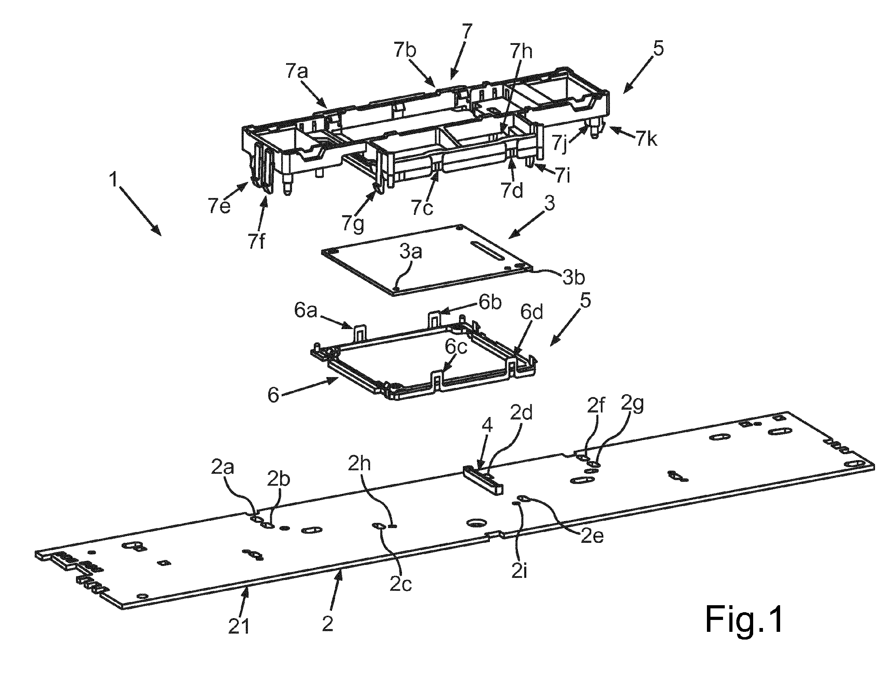

In Fig. 1 ist in einer Explosionsdarstellung ein Elektronikmodul 1 für ein Haushaltsgerät gezeigt, welches eine erste Leiterplatte 2 und eine dazu separate zweite Leiterplatte 3 aufweist. Die erste Leiterplatte 2 ist rechteckförmig gebildet und im Ausführungsbeispiel als Interaktions-Leiterplatte gestaltet. Sie ist diesbezüglich auch entsprechend mit elektronischen Bauteilen bestückt und mit diesbezüglich entsprechenden weiteren Komponenten elektronisch verbunden.

Die flächenmäßig kleinere zweite Leiterplatte 3 ist im Ausführungsbeispiel eine Multimedia-Leiterplatte und ist dazu ebenfalls entsprechend mit elektronischen Komponenten bestückt und wird diesbezüglich zur dann jeweiligen Steuerung beziehungsweise zum Informations- und Signalaustausch mit vorgesehenen Komponenten des Elektronikmoduls elektrisch verbunden.

Das Elektronikmodul 1 umfasst darüber hinaus einen elektrischen Leiterplatte-zu-Leiterplatte-Steckverbinder 4, welcher leistenförmig ausgebildet ist und elektrische Kontakte aufweist, so dass eine elektrische Kontaktierung mit der Leiterplatte 2 und der Leiterplatte 3 ermöglicht ist und somit auch ein Signalaustausch zwischen den beiden Leiterplatten 2 und 3 gegeben ist. Der Steckverbinder 4 ist auf der ersten Leiterplatte 2 in seiner Endposition in der gezeigten Ausführung in dem Montagezustand vormontiert.

Das Elektronikmodul 1 umfasst darüber hinaus ein separates Haltemodul 5, welches im gezeigten Ausführungsbeispiel einen Halterahmen aufweist, der ein Halterahmenunterteil 6 umfasst. Dieses ist zur Aufnahme und schwimmenden Lagerung der zweiten Leiterplatte 3 ausgebildet. Darüber hinaus umfasst das Haltemodul 5 ein Halterahmenoberteil 7, welches als Halterahmen für ein nicht gezeigtes Display, beispielsweise ein TFT-Display ausgebildet ist.

Die Halterahmenteile 6 und 7 sind zerstörungsfrei lösbar miteinander verbindbar, wobei hier Rastelemente 6a, 6b, 6c und 6d an dem Halterahmenunterteil 6 vorgesehen sind und korrespondierende Rasthaken 7a, 7b, 7c und 7d an dem Halterahmenoberteil 7 ausgebildet sind. Das Halterahmenoberteil 7 ist einstückig aus Kunststoff ausgebildet, wobei auch das Halterahmenunterteil 6 einstückig aus Kunststoff gestaltet ist.

Darüber hinaus sind an dem Halterahmenoberteil 7 eine Mehrzahl von Schnapphaken 7e, 7f, 7g, 7h, 7i, 7j, 7k ausgebildet, die zur zerstörungsfrei lösbaren Befestigung des gesamten Haltemoduls 5 mit der zweiten Leiterplatte 3 an der ersten Leiterplatte 2 ausgebildet sind. Zur diesbezüglichen Befestigung weist die erste Leiterplatte 2 Löcher 2a, 2b, 2c, 2d, 2e, 2f und 2g auf, durch welche dann die als Schnapphaken 7a bis 7k ausgebildeten Rastelemente hindurchgreifen und auf einer Rückseite auf der ersten Leiterplatte 2, die dem Modul 5 und der zweiten Leiterplatte 3 abgewandt ist, anliegen.

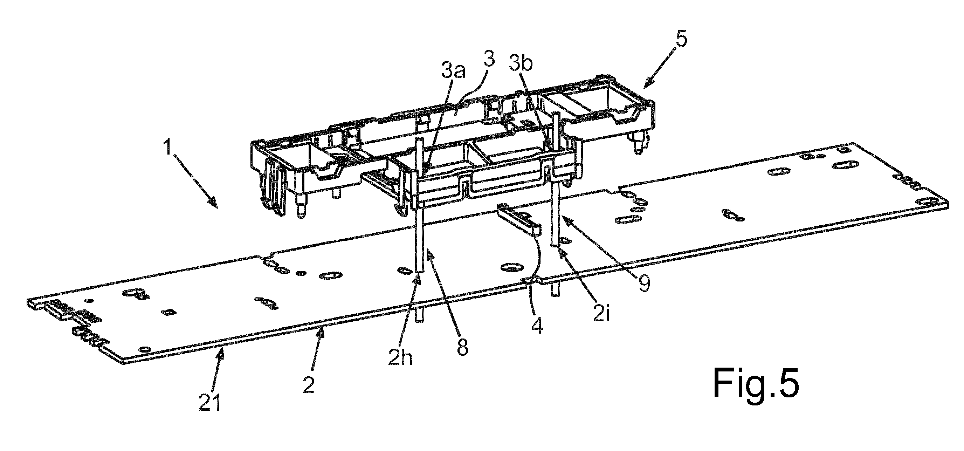

Wesentlich ist, dass die erste Leiterplatte 2 Aufnahmen 2h und 2i aufweist, die als separate und beabstandet zueinander angeordnete durchgängige Löcher gestaltet sind. Darüber hinaus weist auch die zweite Leiterplatte 3 Aufnahmen 3a und 3b auf, die als durchgängige Löcher ausgebildet sind. Insbesondere ist vorgesehen, dass die Löcher 2h und 3a mit jeweils kreisrunder Kontur ausgebildet sind, und die Löcher 2i und 3b als Langlöcher ausgebildet sind. Bei der Montage wird durch diese Löcher 2h und 3a ein erstes Montage-Justageelement 8 (Fig. 5) und durch die Löcher 2i und 3b ein dazu separates weiteres Montage-Justageelement 9 hindurchgeführt. Dadurch wird während der Montage des Elektronikmoduls 1 eine Lageausrichtung zwischen den beiden Leiterplatten 2 und 3 erreicht, bevor die Leiterplatte 2 mit dem bereits darauf befestigten Steckverbinder 4 die zweite Leiterplatte 3 mechanisch und dann auch elektrisch kontaktiert. Bei der Montage wird dann, wenn diese Justageelemente 8 und 9, die als Stifte beziehungsweise Stäbe ausgebildet sind, in den entsprechenden Löchern 2i, 3b, 2h, 3a hindurcherstreckend angeordnet sind, ein weiteres Aufeinanderzubewegen der ersten Leiterplatte 2 und der zweiten Leiterplatte 3, insbesondere des Zwischenmoduls, welches bereits mit dem Haltemodul 5 und der zweiten Leiterplatte 3 zwischengefertigt ist, durchgeführt, wobei die dann noch immer weiter vorhandenen und eingesteckten Justageelementen 8 und 9 dann auch eine mechanische und elektrische Kontaktierung zwischen dem Steckverbinder 4 und der zweiten Leiterplatte 3 erreicht wird, wobei dann auch im weiteren Montageverfahren automatisch das Haltemodul 5 mit der zweiten Leiterplatte 3 auf der ersten Leiterplatte 2 einschnappend befestigt wird.

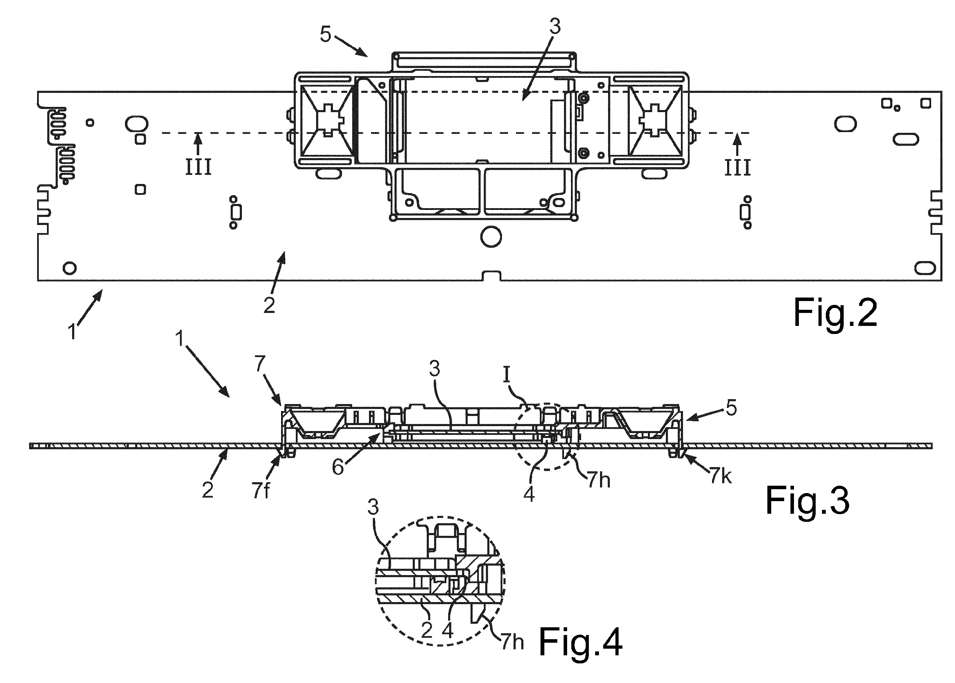

In Fig. 2 ist eine Draufsicht auf das Elektronikmodul 1 mit den in Fig. 1 in der Explosionsdarstellung gezeigten Komponenten dargestellt, wobei hier der zusammengefügte Endzustand dieser Komponenten gezeigt ist.

In Fig. 3 ist eine Schnittdarstellung entlang der Schnittlinie III-III in Fig. 2 gezeigt. Der verschnappte Zustand des Moduls 5 mit der zweiten Leiterplatte 3 auf der ersten Leiterplatte 2 ist gezeigt. Es ist darüber hinaus auch zu erwähnen, dass die zweite Leiterplatte 3 in dem Haltemodul 5, insbesondere dem Halterahmenunterteil 6 schwimmend gelagert angeordnet ist. Durch diese Lagerung wird eine Relativbewegung möglich, so dass einwirkende Kräfte dann auf den Steckverbinder 4 nicht voll umfänglich übertragen werden und daher die mechanische und auch elektrische Verbindung zwischen den Leiterplatten 2 und 3 über den Steckverbinder 4 nicht beeinträchtigt ist.

In Fig. 4 ist eine vergrößerte Darstellung des Teilausschnitts I in Fig. 3 gezeigt.

In Fig. 5 ist in einer perspektivischen Darstellung ein Montagezwischenzustand gezeigt, bei dem Justageelemente 8 und 9 durch die Öffnungen beziehungsweise Löcher 2h und 3a sowie 2i und 3b hindurchgeführt sind und darüber hinaus ein weiteres vormontiertes Zwischenmodul beziehungsweise eine vormontierte Einheit, die das Haltemodul 5 und die zweite Leiterplatte 3 umfasst, bereitgestellt ist. Ausgehend von diesem Montagezwischenzustand, bei dem zu erkennen ist, dass der auf der ersten Leiterplatte 2 bereits montierte Steckverbinder 4 noch beabstandet und in keinem mechanischen oder elektrischen Kontakt mit der zweiten Leiterplatte 3 steht, werden die Leiterplatten 2 und 3 aufeinander zu bewegt und es wird dann bei noch vorhandenen und eingeführten Justageelementen 8 und 9 auch diese Verbindung hergestellt. Ist dann der in Fig. 2 und Fig. 3 sowie Fig. 4 gezeigte montierte Endzustand der genannten Bauteile erreicht, wird dann im Nachgang bei dem Montageverfahren ein Herausziehen und vollständiges Entfernen der Justageelemente 8 und 9 durchgeführt, so dass diese im montierten Endzustand des Elektronikmoduls 1 nicht mehr vorhanden sind.

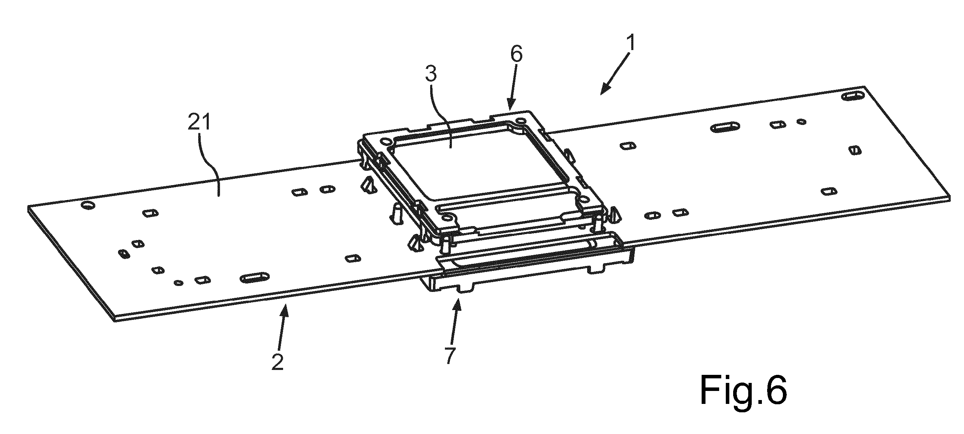

In Fig. 6 ist in einer weiteren perspektivischen Darstellung ein montierter Endzustand eines weiteren Ausführungsbeispiels eines Elektronikmoduls 1 gezeigt, wobei hier eine Ansicht auf eine Unterseite 21 der ersten Leiterplatte 2 gezeigt ist. Bei dieser Ausführung ist vorgesehen, dass das Halterahmenunterteil 6 und das Halterahmenoberteil 7 an unterschiedlichen Seiten der ersten Leiterplatte 2 und somit gegenüberliegenden Seiten der ersten Leiterplatte 2 angeordnet sind. Zwischen dem Halterahmenunterteil 6 und der Unterseite 21 der ersten Leiterplatte 2 ist die zweite Leiterplatte 3 angeordnet und vorzugsweise ist diese ebenfalls wiederum schwimmend gelagert und in dem Halterahmenunterteil 6 positioniert. Auch hier ist das Halterahmenunterteil 6 zerstörungsfrei lösbar an der ersten Leiterplatte 2 befestigt, wobei auch das Halterahmenoberteil 6 zerstörungsfrei lösbar an der ersten Leiterplatte 2 befestigt ist.

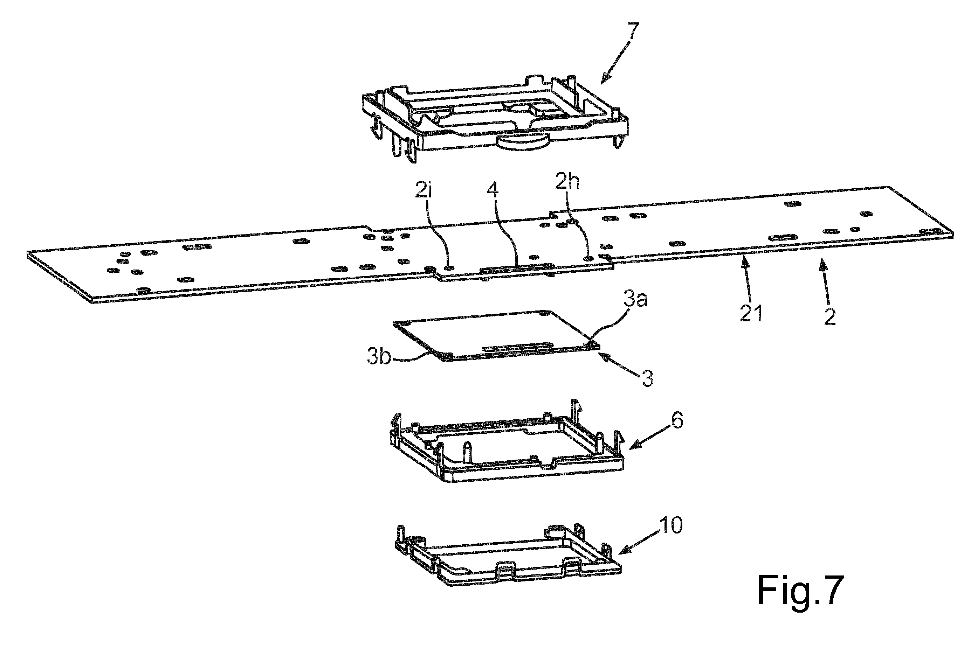

Gemäß der Explosionsdarstellung in Fig. 7, in der das Ausführungsbeispiel in Fig. 6 gezeigt ist, weist auch hier wiederum die erste Leiterplatte 2 Löcher 2h und 2i zum Hindurchführen der Justageelemente 8 und 9 auf. Auch die zweite Leiterplatte 3 weist wiederum 3a und 3b auf, die zum Hindurchführen der Justageelemente 8 und 9 nur während der Montage vorgesehen sind. Zusätzlich zum Halterahmenunterteil 6 ist hier noch ein Deckel 10 vorgesehen, der die zweite Leiterplatte 3 von unten abdeckt. Dieser Deckel 10 kann zerstörungsfrei lösbar mit dem Halterahmenunterteil 6 und/oder der ersten Leiterplatte 2 angeordnet sein, wobei hier auch beispielsweise Steckelemente und/oder Rastelemente zur Ausgestaltung einer derartigen lösbaren Verbindung vorgesehen sind.

### Bezugszeichenliste

- 1: Elektronikmodul
- 2: erste Leiterplatte
- 2a-2g: Löcher
- 2h-2i: Aufnahmen
- 3: zweite Leiterplatte
- 3a, 3b: Aufnahmen
- 4: Steckverbinder
- 5: Haltemodul
- 6: Halterahmenunterteil
- 6a-6d: Rastelemente
- 7: Halterahmenoberteil
- 7a-7d: Rasthaken
- 7e-7k: Schnapphaken
- 8: Justageelement
- 9: Justageelement
- 10: Deckel
- 21: Unterseite

## Patentansprüche

1. Elektronikmodul (1) für ein Haushaltsgerät, mit einer ersten Leiterplatte (2) und einer separaten zweiten Leiterplatte (3), die beabstandet zueinander angeordnet sind und mit einem Leiterplatte-zu-Leiterplatte-Steckverbinder (4) elektrisch verbunden sind, **dadurch gekennzeichnet, dass** die beiden Leiterplatten (2, 3) Aufnahmen (2h, 2i, 3a, 3b) für Montage-Justageelemente (8, 9) aufweisen, welche zur Justage der Leiterplatten (2, 3) zueinander bei der Montage in die Aufnahmen (2h, 2i, 3a, 3b) einführbar sind.

2. Elektronikmodul (1) nach Anspruch 1, **dadurch gekennzeichnet, dass** jede Leiterplatte (2, 3) zumindest zwei separate Aufnahmen (2h, 2i, 3a, 3b) aufweist.

3. Elektronikmodul (1) nach Anspruch 1 oder 2, **dadurch gekennzeichnet, dass** die Aufnahmen durchgängige Löcher (2h, 2i, 3a, 3b) sind.

4. Elektronikmodul (1) nach Anspruch 3, **dadurch gekennzeichnet, dass** zumindest ein Loch (2h, 2i, 3a, 3b), insbesondere alle Löcher (2h, 2i, 3a, 3b), eckenfrei sind.

5. Elektronikmodul (1) nach Anspruch 4, **dadurch gekennzeichnet, dass** zumindest ein Loch kreisrund oder als Langloch ausgebildet ist.

6. Elektronikmodul (1) nach einem der vorhergehenden Ansprüche, **dadurch gekennzeichnet, dass** die zweite Leiterplatte (3) flächenmäßig kleiner als die erste Leiterplatte (1) ausgebildet ist.

7. Elektronikmodul (1) nach einem der vorhergehenden Ansprüche, **dadurch gekennzeichnet, dass** eine Leiterplatte (3) in einem rahmenartigen Haltemodul (5) angeordnet ist.

8. Elektronikmodul (1) nach Anspruch 7, **dadurch gekennzeichnet, dass** die Leiterplatte (3) in dem rahmenartigen Haltemodul (5) schwimmend gelagert ist.

9. Elektronikmodul (1) nach Anspruch 7 oder 8, **dadurch gekennzeichnet, dass** das Haltemodul (5) ein Halterahmenoberteil (7) und ein Halterahmenunterteil (6) aufweist und die Leiterplatte (3) zwischen dem Halterahmenoberteil (7) und dem Halterahmenunterteil (6) angeordnet ist.

10. Elektronikmodul (1) nach Anspruch 9, **dadurch gekennzeichnet, dass** das Halterahmenoberteil (7) und das Halterahmenunterteil (6) durch Rasteelemente und/oder Steckelemente zerstörungsfrei lösbar miteinander verbindbar sind.

11. Elektronikmodul (1) nach einem der Ansprüche 7 bis 10, **dadurch gekennzeichnet, dass** das Haltemodul (5) zerstörungsfrei lösbar an der anderen, insbesondere ersten, Leiterplatte (2) befestigt ist.

12. Elektronikmodul (1) nach einem der vorhergehenden Ansprüche, **dadurch gekennzeichnet, dass** der Leiterplatte-zu-Leiterplatte-Steckverbinder (4) mit Rastelementen und/oder Steckelementen, insbesondere nur mit Rastelementen und/oder Steckelementen, mit den Leiterplatten (2, 3) verbunden ist.

13. Verfahren zur Montage eines Elektronikmoduls (1) für ein Haushaltsgerät, bei welchem eine erste Leiterplatte (2) beabstandet zu einer zweiten Leiterplatte (3) in dem Elektronikmodul (1) angeordnet wird und die beiden Leiterplatten (2, 3) mit einem Leiterplatte-zu-Leiterplatte-Steckverbinder (4) elektrisch verbunden werden, **dadurch gekennzeichnet, dass** die beiden Leiterplatten (2, 3) mit Aufnahmen (2h, 2i, 3a, 3b) ausgebildet werden, in welche bei der Montage Montage-Justageelemente (8, 9) zur Ausrichtung der Leiterplatten (2, 3) zueinander eingeführt werden.

14. Verfahren nach Anspruch 13, **dadurch gekennzeichnet, dass** die Justageelemente (8, 9) als vorauseilend ausgebildet und angeordnet werden und somit vor dem mechanischen Kontaktieren des Leiterplatte-zu-Leiterplatte-Steckverbinders (4) beider Leiterplatten (2, 3) in die Aufnahmen (2h, 2i, 3a, 3b) in beiden Leiterplatten (2, 3) sich erstreckend eingeführt werden.

15. Verfahren nach Anspruch 13 oder 14, **dadurch gekennzeichnet, dass** die Justageelemente (8, 9) als Justagestifte ausgebildet werden und die Justageelemente (8, 9) als separate Komponenten bereitgestellt werden, welche nach dem mechanischen Verbinden beider Leiterplatten (2, 3) mit dem Leiterplatte-zu-Leiterplatte-Steckverbinder (4) von den Leiterplatten (2, 3) entfernt werden.
